# EUROPEAN PATENT APPLICATION

(11) **EP 4 471 090 A1**
(43) Date of publication of application: **04.12.2024**
(21) Application number: 23743130.9
(22) Date of filing: 10.01.2023
(51) Int. Cl.: C08L 71/00, C08L 83/05, H01L 23/29, H01L 23/31

(54) **CURABLE PERFLUOROPOLYETHER GEL COMPOSITION, CURED PERFLUOROPOLYETHER GEL PRODUCT, AND ELECTRIC/ELECTRONIC COMPONENT SEALED USING SAID CURED PRODUCT**

(30) Priority: 24.01.2022 JP 2022008714
(71) Applicant: SHIN-ETSU CHEMICAL CO., LTD., Tokyo 1000005 (JP)
(72) Inventor: YASUDA, Hiroyuki, Annaka-shi, Gunma 379-0224 (JP)
(74) Representative: Sonnenhauser, Thomas Martin
(86) International application number: PCT/JP2023/000243
(87) International publication number: WO 2023/140134

(57) **Abstract**

The present invention is a curable perfluoropolyether gel composition including: (A) 10 to 90 parts by mass of a linear perfluoropolyether compound containing two or more alkenyl groups per molecule, wherein the main chain has no branched structure; (B) 10 to 90 parts by mass of a linear perfluoropolyether compound without reactive functional group per molecule, wherein a total amount of (A) and (B) is 100 parts by mass; (C) a curing effective amount of an organohydrogenpolysiloxane having two or more SiH groups per molecule; and (D) a catalytic amount of a hydrosilylation reaction catalyst, wherein the composition has a viscosity of 1000 mPa·s or less, and provides a perfluoropolyether gel cured product having a resin modulus of 0.1 to 200 kPa·s. This provides the curable perfluoropolyether gel composition with a low viscosity and good defoaming property before curing, and the cured product has excellent heat resistance.

## Description

### TECHNICAL FIELD

The present invention relates to: a curable perfluoropolyether gel composition that has excellent heat resistance, chemical resistance, low-temperature characteristics, adhesiveness, etc. after curing, that particularly exhibits good foam escape in a short time even with use for potting, an encapsulating material, a coating material, etc. for an electric or electronic component due to a low viscosity before curing, and that can be suitably used for improving productivity; a perfluoropolyether gel cured product comprising a cured product of this composition; and an electric or electronic component etc. encapsulated with this cured product.

### BACKGROUND ART

Cured products of silicone rubber have been used as potting or an encapsulating material for an electric or electronic component, and a coating material for protecting a control circuit device, such as a power transistor, an IC, and a capacitor, from externally thermal and mechanical faults by utilizing its excellent electric and thermal insulability, stable electric characteristics, and flexibility. Specifically, a gel-like cured product is particularly useful for the above use due to its low modulus.

Representative examples of a silicone rubber composition to form such a gel-like cured product include an addition-curable organopolysiloxane composition. As this addition-curable organopolysiloxane composition, for example, known is a composition containing an organopolysiloxane having a vinyl group bonded to a silicon atom and an organohydrogenpolysiloxane having a hydrogen atom bonded to a silicon atom for a crosslinking reaction in the presence of a platinum-based catalyst to obtain a silicone gel (Patent Documents 1, 2, and 3).

As a fluorosilicone gel composition, known is a composition containing an organopolysiloxane having a trifluoropropyl group (Patent Document 4).

However, the silicone gel obtained with these addition-curable organopolysiloxane compositions tends to cause swelling and deterioration with chemical reagents such as a strong base and a strong acid, and solvents such as toluene, an alcohol, and gasoline. Thus, such a composition has a problem of difficulty in retention of its properties.

Accordingly, proposed in order to solve this problem are: a fluorine gel composition containing a base compound containing a divalent perfluoropolyether group having two alkenyl groups in one molecule, an organohydrogenpolysiloxane containing a hydrogen atom bonded to a silicon atom, and a platinum-based catalyst; and a fluorine-gel-like cured product formed by curing this composition (Patent Document 5).

However, when the aforementioned gel is used for potting for an electric or electronic component, the component needs to be left for 10 minutes or longer in order to remove foam generated during injection, which leads to deterioration of productivity. Although it is also investigated to forcibly remove the foam by a pressure-reduction process on each component after injecting the composition in some cases, there have problems of requirement of preparing a special apparatus and similar deterioration of productivity because the pressure-reduction process and atmosphere release consume time.

### CITATION LIST

### PATENT LITERATURE

Patent Document 1: JP S56-143241 A
Patent Document 2: JP S63-35655 A
Patent Document 3: JP S63-33475 A
Patent Document 4: JP H7-324165 A
Patent Document 5: JP H11-116685 A

### SUMMARY OF INVENTION

### TECHNICAL PROBLEM

The present invention has been made in view of the above circumstances. An object of the present invention is to provide a curable perfluoropolyether gel composition that has excellent heat resistance, chemical resistance, low-temperature characteristics, adhesiveness, etc. after curing, that particularly exhibits good defoaming property in a short time even with use for potting, an encapsulating material, a coating material, etc. for an electric or electronic component due to a low viscosity before curing, and that can be suitably used for improving productivity; a perfluoropolyether gel cured product comprising a cured product of this composition; and an electric or electronic component etc. encapsulated with this cured product.

### SOLUTION TO PROBLEM

To solve the above problem, the present invention provides a curable perfluoropolyether gel composition comprising following components (A) to (D):
(A) 10 to 90 parts by mass of a linear perfluoropolyether compound containing at least two alkenyl groups in one molecule and a perfluoropolyether structure having a repeating unit of -CₐF₂ₐO- in a main chain, wherein the main chain has no branched structure, and "a" represents an integer of 1 to 6;
(B) 10 to 90 parts by mass of a linear perfluoropolyether compound containing a perfluoropolyether structure having no reactive functional group in one molecule, wherein a total amount of the component (A) and the component (B) is 100 parts by mass;
(C) a curing effective amount of an organohydrogenpolysiloxane having at least two hydrogen atoms bonded to a silicon atom in one molecule; and
(D) a catalytic amount of a hydrosilylation reaction catalyst,
wherein the composition before curing has a viscosity at 23°C of 1000 mPa·s or less, and the composition provides a perfluoropolyether gel cured product having a resin modulus at 25°C after curing of 0.1 to 200 kPa·s.

The curable perfluoropolyether gel composition containing the components (A) to (D) as the present invention is the curable perfluoropolyether gel composition (fluorine-containing curable gel composition) that has excellent heat resistance, chemical resistance, low-temperature characteristics, humidity resistance, low gas-permeating property, etc. after curing, that particularly exhibits good defoaming property in a short time even with use for potting, an encapsulating material, a coating material, etc. for an electric or electronic component due to a low viscosity before curing, and that can be suitably used for improving productivity.

The present invention provides the above curable perfluoropolyether gel composition, wherein the component (A) is a linear perfluoropolyether compound represented by the following general formula (1),

CH₂=CH-(X')ₚ-Rf¹-(X')ₚ-CH=CH₂ (1)

wherein X' represents -CH₂-, -OCH₂-, -CH₂OCH₂-, or - CO-NR²-Y'-, Y' represents -CH₂- or a group represented by the following structural formula (Z'), 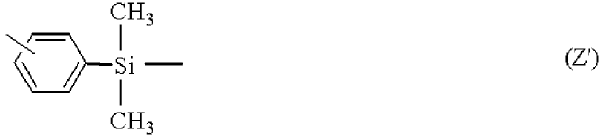 which is a dimethylphenylsilylene group represented with an ortho, meta, or para substitution position,
R² represents a hydrogen atom, a methyl group, a phenyl group, or an allyl group; "p" independently represents 0 or 1; and Rf¹ represents a perfluoropolyether structure represented by the general formula -[CₐF₂ₐO]_{w}-CF₂-, wherein "a" represents an integer of 1 to 6, "w" represents an integer of 1 to 300, and Rf¹ has no branched structure.

The curable perfluoropolyether gel composition containing such a component (A) is the fluorine-containing curable gel composition that has excellent heat resistance, chemical resistance, low-temperature characteristics, humidity resistance, low gas-permeating property, etc. after curing, that particularly exhibits good defoaming property in a short time due to a low viscosity before curing, and that can be more suitably used for improving productivity.

The present invention provides the above curable perfluoropolyether gel composition, wherein the component (B) is at least one linear perfluoropolyether compound selected from the group consisting of:
a compound represented by the following general formula (2),

   A-O-(CF₂CF₂CF₂O)_{b}-A (2)
wherein A independently represents a group represented by the formula: CₛF₂ₛ₊₁-, wherein "s" represents an integer of 1 to 3, and "b" represents an integer of 1 to 200; and
a compound represented by the following general formula (3),

   A-O-(CF₂O)_{d}(CF₂CF₂O)ₑ-A (3)
wherein A represents the above, "d" and "e" each represent an integer of 0 to 200, and d+e = 1 to 250.

The curable perfluoropolyether gel composition containing such a component (B) yields the gel composition and its cured product. The gel composition has particularly an appropriately reduced viscosity and modulus while keeping physical properties such as heat resistance and chemical resistance.

The present invention provides the above curable perfluoropolyether gel composition further comprising, as necessary, as a component (E), a polyfluoromonoalkenyl compound as an optional component represented by the following general formula (4),

Rf²-(X')_{p'}-CH=CH₂ (4)

wherein X' represents -CH₂-, -OCH₂-, -CH₂OCH₂-, or - CO-NR²-Y'-, Y' represents -CH₂- or a group represented by the following structural formula (Z'), 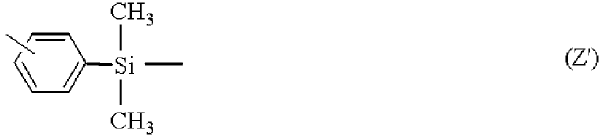 which is a dimethylphenylsilylene group represented with an ortho, meta, or para substitution position,
R² represents a hydrogen atom, a methyl group, a phenyl group, or an allyl group; "p'" represents 0 or 1; and Rf² represents a perfluoropolyether structure represented by the general formula F-[CF(CF₃)CF₂O]_{w'}-CF(CF₃)-, wherein "w'" represents an integer of 1 to 300.

The curable perfluoropolyether gel composition containing such a component (E) yields the gel cured product having an appropriately reduced crosslinking density while keeping physical properties such as chemical resistance.

The curable perfluoropolyether gel composition preferably provides a perfluoropolyether gel cured product having a penetration of 5 to 80 in accordance with ASTM D-1403 (1/4 corn).

Such a curable perfluoropolyether gel composition provides a gel cured product having appropriate softness.

The present invention also provides a perfluoropolyether gel cured product comprising a cured product of the above curable perfluoropolyether gel composition.

Such a perfluoropolyether gel cured product has excellent heat resistance, chemical resistance, low-temperature characteristics, adhesiveness, etc., and is useful for potting, an encapsulating material, a coating material, etc. for an electric or electronic component.

The present invention provides an electric or electronic component encapsulated with the above gel cured product of the curable perfluoropolyether (that is, the perfluoropolyether gel), specifically a gas pressure sensor, a liquid pressure sensor, a temperature sensor, a humidity sensor, a rotation sensor, a G sensor (gravity sensor), a timing sensor, an airflow meter, an electronic circuit, a computer control unit, and a semiconductor module.

As above, the electric or electronic component having excellent heat resistance, chemical resistance, low-temperature characteristics, adhesiveness, etc. can be manufactured with good productivity by using the curable perfluoropolyether gel composition of the present invention, which removes the foam generated in dispensing in a short time to lead to improvement of production efficiency, and encapsulating the electric or electronic component with the perfluoropolyether gel cured product formed by curing this composition.

### ADVANTAGEOUS EFFECTS OF INVENTION

As noted above, the curable perfluoropolyether gel composition of the present invention can provide the curable perfluoropolyether gel composition that has excellent heat resistance, chemical resistance, low-temperature characteristics, adhesiveness, etc., that particularly exhibits good defoaming property in a short time even with use for potting, an encapsulating material, a coating material, etc. for an electric or electronic component due to a low viscosity before curing, and that can be suitably used for improving productivity.

### BRIEF DESCRIPTION OF DRAWING

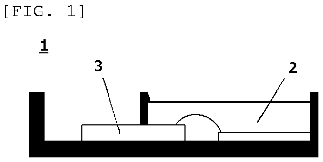

FIG. 1 is a schematic view illustrating an airflow meter used for a heat-shock test.

### DESCRIPTION OF EMBODIMENTS

As noted above, there has been a demand for development of: a fluorine-containing curable gel composition that has excellent heat resistance, chemical resistance, low-temperature characteristics, humidity resistance, low gas-permeating property, etc. after curing, that particularly exhibits good defoaming property in a short time even with use for potting, an encapsulating material, a coating material, etc. for an electric or electronic component due to a low viscosity before curing, and that can be suitably used for improving productivity; and the electric or electronic component comprising a cured product thereof.

The present inventor has made earnest study to achieve the above object, and consequently found that the specific perfluoropolyether gel composition according to the present invention can yield: a perfluoropolyether gel composition that can reduce the viscosity while keeping chemical resistance and solvent resistance compared with conventional fluorine-containing gel compositions to lead to improvement of productivity; particularly a composition that yields a cured product without foam after curing. This finding has led to completion of the present invention.

Specifically, the present invention is a curable perfluoropolyether gel composition comprising following components (A) to (D):
(A) 10 to 90 parts by mass of a linear perfluoropolyether compound containing at least two alkenyl groups in one molecule and a perfluoropolyether structure having a repeating unit of -CₐF₂ₐO- in a main chain, wherein the main chain has no branched structure, and "a" represents an integer of 1 to 6;
(B) 10 to 90 parts by mass of a linear perfluoropolyether compound containing a perfluoropolyether structure having no reactive functional group in one molecule, wherein a total amount of the component (A) and the component (B) is 100 parts by mass;
(C) a curing effective amount of an organohydrogenpolysiloxane having at least two hydrogen atoms bonded to a silicon atom in one molecule; and
(D) a catalytic amount of a hydrosilylation reaction catalyst,
wherein the composition before curing has a viscosity at 23°C of 1000 mPa·s or less, and the composition provides a perfluoropolyether gel cured product having a resin modulus at 25°C after curing of 0.1 to 200 kPa·s.

Hereinafter, the present invention will be described in detail, but the present invention is not limited thereto. The term "at least" herein means a lower limit of a numerical range. For example, descriptions "at least two" and "at least one" respectively means "two or more" and "one or more".

### Component (A)

The component (A) contained in the curable perfluoropolyether gel composition of the present invention acts as a base compound (base polymer) of the curable perfluoropolyether gel composition of the present invention. The component (A) is a linear perfluoropolyether compound containing at least two alkenyl groups in one molecule and containing a perfluoropolyether structure containing a repeating unit of -CₐF₂ₐO- in a main chain, wherein the main chain contains no branched structure, and "a" represents an integer of 1 to 6. That is, the component (A) is a linear perfluoropolyether compound containing a divalent perfluorooxyalkylene structure. A number of the alkenyl groups in one molecule of the compound is two or more. The upper limit thereof is not particularly limited, and may be, for example, 2 to 12, preferably 2 to 8, and more preferably 2 to 6.

Here, the perfluorooxyalkylene structure contains many repeating structures of the oxyalkylene unit represented by -CₐF₂ₐO-, wherein "a" in each unit independently represents an integer of 1 to 6, and examples thereof include a structure represented by the following general formula (I),

-[CₐF₂ₐO]_{w}-CF₂- (I)

wherein "w" represents an integer of 1 to 300, preferably an integer of 2 to 300, more preferably an integer of 5 to 250, and further preferably an integer of 10 to 200.

Examples of each of the repeating units -CₐF₂ₐO- to constitute the perfluorooxyalkylene structure represented by the formula (I) (namely, the oxyalkylene unit) include the following structures. The perfluoroalkyl ether structure may be singly composed of one of these repeating structures, or may be a combination of two or more.

-CF₂O-

-CF₂CF₂O-

-CF₂CF₂CF₂O-

-CF₂CF₂CF₂CF₂O-

-CF₂CF₂CF₂CF₂CF₂CF₂O-

Among these, the following structures are particularly preferable.

-CF₂O-

-CF₂CF₂O-

-CF₂CF₂CF₂O-

In the present invention, the "linear" main chain means that the repeating unit -CₐF₂ₐO- (oxyalkylene unit) to constitute the perfluoropolyether structure (perfluorooxyalkylene structure) in the main chain is linearly bonded to each other.

Meanwhile, the term "branched structure" in the present invention means that the repeating unit -CₐF₂ₐO-(oxyalkylene unit) to constitute the perfluoropolyether structure (perfluorooxyalkylene structure) itself in the main chain is a branched oxyalkylene unit (for example, -CF(CF₃)CF₂O-,-C(CF₃)₂O-, etc.). The term "no branched structure" in the main chain means that the perfluorooxyalkylene unit to constitute the perfluoropolyether structure (perfluorooxyalkylene structure) in the main chain is a perfluorooxyalkylene unit having no branch (for example, a linear perfluorooxyalkylene unit such as -CF₂CF₂O- and - CF₂CF₂CF₂O-).

In the present invention, it is essential that the main chain of the component (A) is the perfluoropolyether structure having no branched structure (that is, having no branched oxyalkylene unit).

Among linear perfluoropolyether structures, it is commonly known that a perfluoropolyether compound having a branched structure has a higher viscosity than a perfluoropolyether having no branched structure. Therefore, use of the perfluoropolyether having no branched structure for the component (A) can achieve reduction in the viscosity of the composition, which is needed for improvement of productivity.

The alkenyl group in the linear perfluoropolyether compound of this component (A) preferably has 2 to 8, particularly 2 to 6, carbon atoms, and preferably has a CH₂=CH- structure at the terminal. For example, groups having a CH₂=CH- structure at the terminal, such as a vinyl group, an allyl group, a propenyl group, an isopropenyl group, a butenyl group, and a hexenyl group, are preferable, and specifically a vinyl group and an allyl group are preferable. This alkenyl group may be directly bonded to both the terminals of the perfluoropolyether structure, specifically a divalent perfluorooxyalkylene structure, to constitute the main chain of the linear perfluoropolyether compound, or may be bonded via a divalent linking group. Examples of the divalent linking group include -CH₂-, -CH₂O-, -CH₂OCH₂-, or -Y-NR-CO-, wherein Y represents -CH₂- or a group represented by the following structural formula (Z), 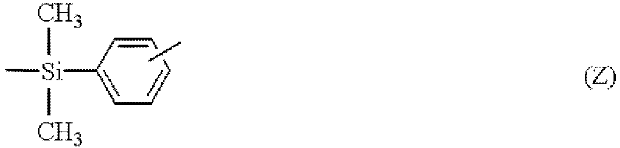 which is a dimethylphenylsilylene group represented with an ortho, meta, or para substitution position,
and R represents a hydrogen atom, a methyl group, a phenyl group, or an allyl group. The component (A) contains at least two alkenyl groups in one molecule.

Examples of the component (A) include a polyfluorodialkenyl compound represented by the following general formula (5) or (6),

CH₂=CH-(X)ₚ-Rf¹-(X')ₚ-CH=CH₂ (5)

CH₂=CH-(X)ₚ-Q-Rf¹-Q-(X')ₚ-CH=CH₂ (6)

wherein X independently represents -CH₂-, -CH₂O-, - CH₂OCH₂-, or -Y-NR¹-CO-, wherein Y represents -CH₂- or a group represented by the following structural formula (Z), R¹ represents a hydrogen atom, a methyl group, a phenyl group, or an allyl group, X' represents -CH₂-, - OCH₂-, -CH₂OCH₂-, or -CO-NR²-Y'-, wherein Y' represents - CH₂- or a group represented by the following structural formula (Z'), and R² represents a hydrogen atom, a methyl group, a phenyl group, or an allyl group. 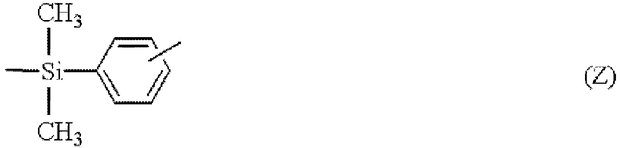 A dimethylphenylsilylene group represented with an ortho, meta, or para substitution position.

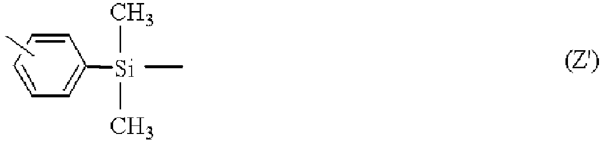

A dimethylsilylphenylene group represented with an ortho, meta, or para substitution position.

Rf¹ represents a divalent perfluoropolyether structure (perfluorooxyalkylene structure), and is preferably represented by the formula (I), namely - [CₐF₂ₐO]_{w}-CF₂-. Q represents a divalent hydrocarbon group having 1 to 15 carbon atoms and optionally containing an ether bond. Q specifically represents an alkylene group or an alkylene group optionally containing an ether bond. "p" independently represents 0 or 1.

Examples of such a linear perfluoropolyether compound of the component (A) include compounds represented by the following general formula (1),

CH₂=CH-(X')ₚ-Rf¹-(X')ₚ-CH=CH₂ (1)

wherein X', Rf¹, and "p" represent are same as above, and
the linear perfluoropolyether compound is preferably a polyfluorodialkenyl compound represented by the following general formula (1'),

   CH=CH₂-(X')ₚ-CF₂O(CF₂CF₂O)_{g}(CF₂O)ₕCF₂-(X')ₚ-CH=CH₂ (1')
a perfluoropolyether structure having no branched structure, wherein X' and "p" are same as above, "g" and "h" each represents an integer of 0 to 200, preferably an integer of 1 to 150, more preferably an integer of 5 to 120, and further preferably an integer of 10 to 100, and g+h = 1 to 250, preferably 5 to 240, more preferably 10 to 220, and further preferably 40 to 200.

A proportion of the component (A) in 100 parts by mass of the total amount of the component (A) and the component (B) described later is 10 to 90 parts by mass, and preferably 15 to 85 parts by mass. If this blending amount is less than 10 parts by mass, the obtained composition may have an excessively low modulus to exhibit flowability. If the blending amount is more than 90 parts by mass, the modulus may increase to deteriorate adhesiveness to the substrate.

The linear perfluoropolyether compound represented by the general formula (1) has a weight-average molecular weight of desirably 3,000 to 100,000, particularly desirably 4,000 to 50,000 in terms of polyethylene in molecular-weight distribution measurement by gel permeation chromatography (GPC) analysis with a fluorine-based solvent as an eluent solvent. The weight-average molecular weight of 3,000 or more reduces swelling with gasoline or various solvents. Specifically, swelling with gasoline becomes 6% or less to satisfy characteristics as a member requiring gasoline resistance. The weight-average molecular weight of 100,000 or less is practical because of not excessively high viscosity and excellent operability. Note that a value of a polymerization degree (m+n) of the linear perfluoropolyether compound represented by the general formula (1) can also be determined as a number-average polymerization degree, a weight-average polymerization degree, etc. in term of polyethylene in the molecular-weight distribution measurement with the permeation chromatography (GPC) analysis with a fluorine-based solvent as an eluent solvent. These number-average polymerization degree and number-average molecular weight can also be calculated from a ratio between a terminal structure and a repeating unit structure obtained by ¹⁹F-NMR spectrum.

In the present invention, usable as the component (A) is a product in which the aforementioned linear perfluoropolyether compound is subjected in advance to a hydrosilylation reaction with an organosilicon compound containing two SiH groups in the molecule with a common method and condition to extend the chain length for regulation to allow the linear perfluoropolyether compound represented by the formula (1) to have a desired weight-average molecular weight for the purpose. The linear perfluoropolyether compound of the component (A) may be used singly, or may be used in combination of two or more.

### Component (B)

The component (B) of the present invention is a linear perfluoropolyether compound containing a perfluoropolyether structure containing no reactive functional group in one molecule. Blending such a linear perfluoropolyether compound yields a composition having excellent chemical resistance, solvent resistance, and low-temperature characteristics and having a reduced viscosity without impairing the physical properties etc.

In the present invention, the description "containing no reactive functional group" means that a structure does not contain an alkenyl group and a hydrogen atom bonded to a silicon atom (hydrosilyl group represented by SiH), which are involved with the hydrosilylation addition reaction, and an adhesive functional group having a heteroatom (such as an epoxy group, an alkoxysilyl group, an amino group, and a mercapto group) in the molecule.

The component (B) is clearly distinguished from the aforementioned component (A) and the components (C) and (E), described later, in terms of being containing no reactive functional group in the molecule.

As the component (B), one or more (single or two or more) linear perfluoropolyether compounds selected from the group consisting of compounds represented by the following general formulae (2) and (3) may be used.

A-O-(CF₂CF₂CF₂O)_{b}-A (2)

wherein A independently represents a group represented by the formula: CₛF₂ₛ₊₁- ("s" represents an integer of 1 to 3), and "b" represents an integer of 1 to 200; and

   A-O-(CF₂O)_{d}(CF₂CF₂O)ₑ-A (3)
wherein A represents the same as above, and "d" and "e" each represent an integer of 0 to 200, and d+e = 1 to 250.

Specific examples of the component (B) include the following compounds.

Note that the following "b" or a sum of the following "d" and "e" satisfies the above requirement.

CF₃O-(CF₂CF₂CF₂O)_{b}-CF₂CF₃

CF₃-O-[(CF₂O)_{d}(CF₂CF₂O)ₑ]-CF₃

wherein "b" represents an integer of 1 to 200, preferably an integer of 2 to 150, more preferably an integer of 5 to 120, and further preferably an integer of 10 to 100; "d" and "e" each represent an integer of 0 to 200, preferably an integer of 1 to 100, more preferably an integer of 5 to 80, and further preferably an integer of 10 to 60; and d+e represents 1 to 250, preferably 5 to 200, more preferably 10 to 150, and further preferably 40 to 100.

In 100 parts by mass of the total amount of the component (A) and the component (B), a proportion of the component (B) is 10 to 90 parts by mass, preferably 15 to 85 parts by mass, and more preferably 20 parts by mass or more. If the blending amount is less than 10 parts by mass, the viscosity of the obtained composition may increase to cause difficulty in removal of foam, and the modulus may become excessively high to deteriorate adhesiveness to the substrate. If the blending amount is more than 90 parts by mass, the modulus may become low to exhibit flowability.

### Component (C)

The component (C) acts as a crosslinking agent and/or a chain-extending agent for the component (A) or the component (E), described later. This component (C) is an organohydrogenpolysiloxane containing at least two, preferably three or more, hydrogen atoms bonded to a silicon atom (hydrosilyl groups represented by SiH) in one molecule. A number of alkenyl groups in one molecule of the component (C) is two or more. The upper limit is not particularly limited, but may be, for example, 2 to 50, preferably 3 to 30, and more preferably 3 to 20. Examples of such a component (C) include known organosilicon compounds described in the Patent Document 5, but not particularly limited.

As the organohydrogenpolysiloxane of the component (C), a fluorine-containing organohydrogenpolysiloxane containing one or more monovalent perfluoroalkyl groups, monovalent perfluorooxyalkyl groups, divalent perfluoroalkylene groups, and/or divalent perfluorooxyalkylene groups in one molecule can be preferably used from the viewpoints of compatibility with the component (A) or the component (E), described later, dispersibility, uniformity of the gel cured product after curing, etc.

Examples of this monovalent or divalent fluorine-containing organic group include perfluoroalkyl groups, perfluorooxyalkyl groups, perfluoroalkylene groups, and perfluorooxyalkylene group represented by the following formulae.

C_{g}F_{2g+1}-

-C_{g}F_{2g}-

In the formulae, "g" represents an integer of 1 to 20, and preferably an integer of 2 to 10. 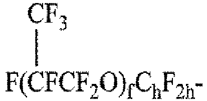 In the formula, "f" represents an integer of 1 to 200, and preferably an integer of 1 to 100, and "h" represents an integer of 1 to 3. 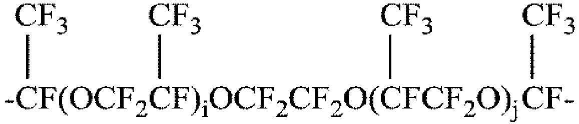 In the formula, "i" and "j" each represent an integer of 1 or more, preferably an integer of 1 to 100, and an average of i+j represents 2 to 200, and preferably 2 to 100.

- (CF₂O)_{d}-(CF₂CF₂O)ₑ-CF₂-

In the formula, "d" and "e" each represent an integer of 1 to 50, and preferably an integer of 1 to 40.

These perfluoroalkyl groups, perfluorooxyalkyl groups, perfluoroalkylene groups, or perfluorooxyalkylene groups are preferably connected with a silicon atom via a divalent linking group. Examples of the divalent linking group include an alkylene group, an arylene group, or a combination thereof, or an ether-bond oxygen atom, an amide bond, a carbonyl bond, an ester bond, a diorganosilylene group, etc. may be interposed between the above groups. Examples thereof include, but not limited to, the following divalent linking groups having 2 to 12 carbon atoms.

-CH₂CH₂-,

-CH₂CH₂CH₂-,

-CH₂CH₂CH₂OCH₂-,

-CH₂CH₂CH₂-NH-CO-,

-CH₂CH₂CH₂-N(Ph)-CO-,

-CH₂CH₂CH₂-N(CH₃)-CO-,

-CH₂CH₂CH₂-N(CH₂CH₃)-CO-,

-CH₂CH₂-Si(CH₃)₂-Ph'-N(CH₃)-CO-,

-CH₂CH₂CH₂-Si(CH₃)₂-Ph'-N(CH₃)-CO-,

-CH₂CH₂CH₂-O-CO-

In the formulae, Ph represents a phenyl group, and Ph' represents a phenylene group.

In the fluorine-containing organohydrogenpolysiloxane of this component (C), examples of a monovalent substituent bonded to the silicon atom other than the monovalent or divalent fluorine-containing organic group and the hydrogen atom bonded to the silicon atom include: alkyl groups, such as a methyl group, an ethyl group, a propyl group, a butyl group, a hexyl group, a cyclohexyl group, an octyl group, and a decyl group; alkenyl groups, such as a vinyl group and an allyl group; aryl groups, such as a phenyl group, a tolyl group, and a naphthyl group; aralkyl groups, such as a benzyl group and a phenylethyl group; and unsubstituted or substituted monovalent hydrocarbon groups having 1 to 20, preferably 1 to 12, carbon atoms in which a part or all of hydrogen atoms in these groups are substituted with a chlorine atom, a cyano group, etc., for example, a chloromethyl group, a chloropropyl group, a cyanoethyl group, etc.

The fluorine-containing organohydrogenpolysiloxane of the component (C) may have any of a cyclic, linear, branched, three-dimensional mesh-like shapes or a combination thereof. A number of the silicon atoms in this fluorine-containing organohydrogenpolysiloxane is not particularly limited, but typically 2 to 60, and preferably approximately 3 to 30.

Examples of such a component (C) having the monovalent or divalent fluorine-containing organic group and the silicon-atom-bonded hydrogen atom include the following compounds. These compounds may be used singly, or may be used in combination of two or more. In the following formulae, Me represents a methyl group, and Ph represents a phenyl group.

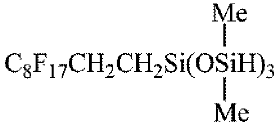

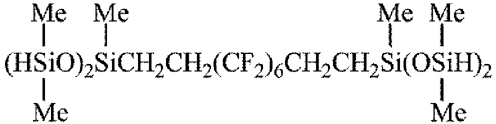

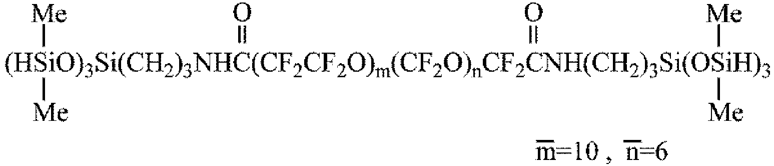

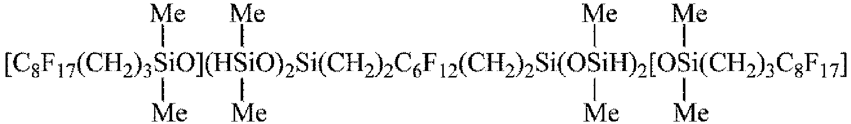

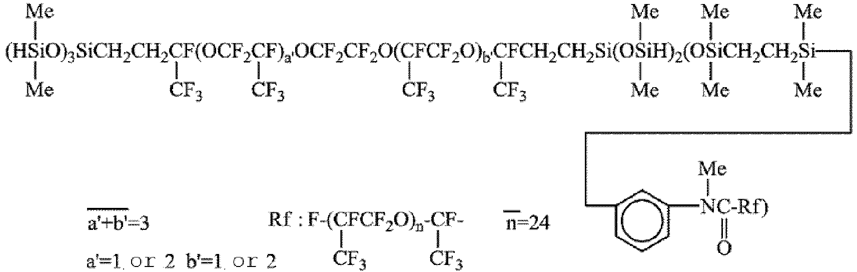

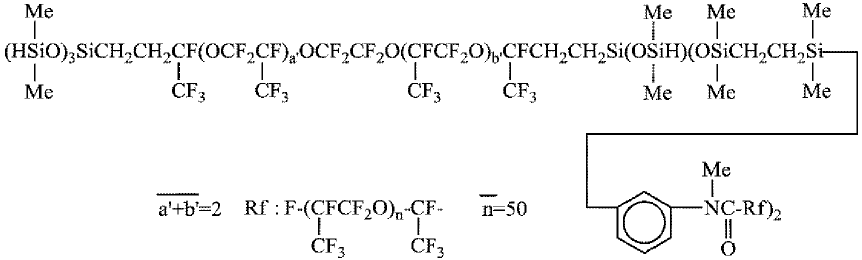

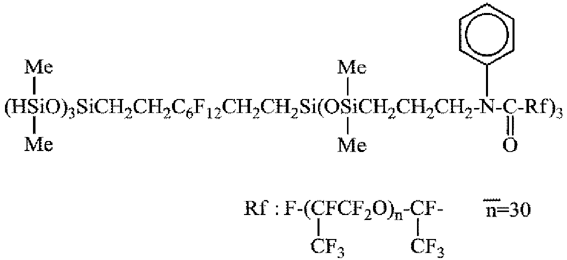

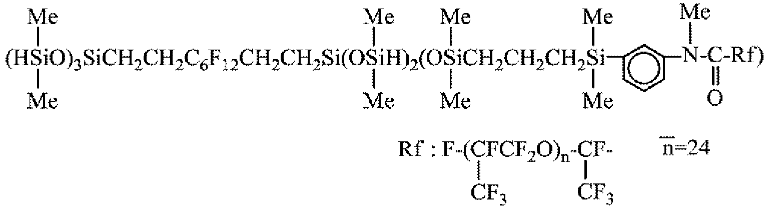

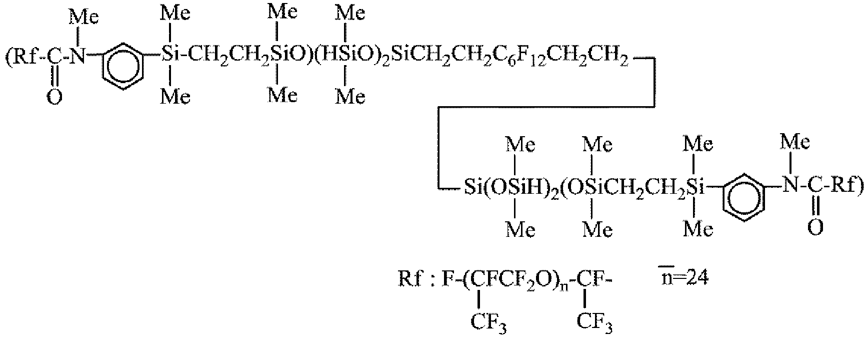

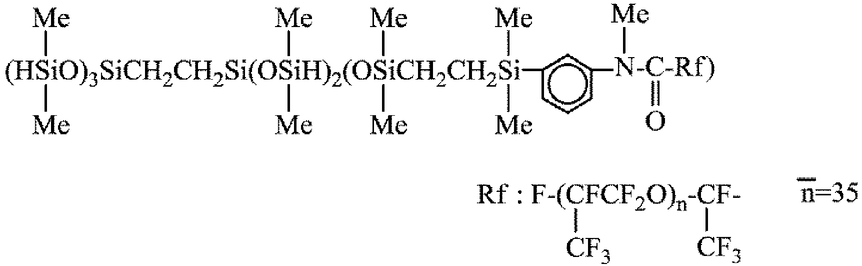

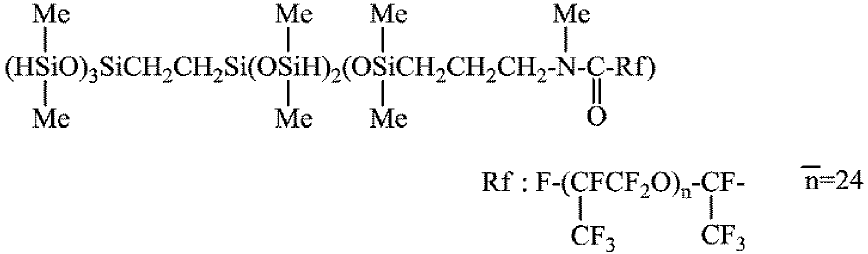

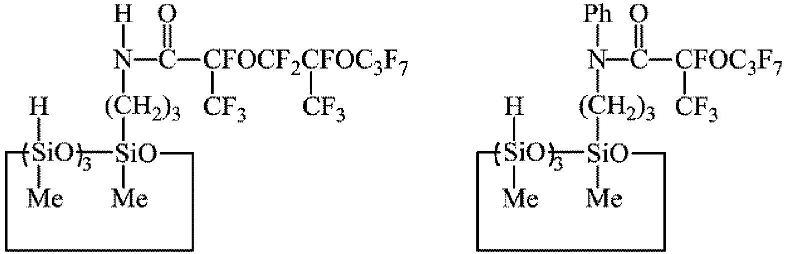

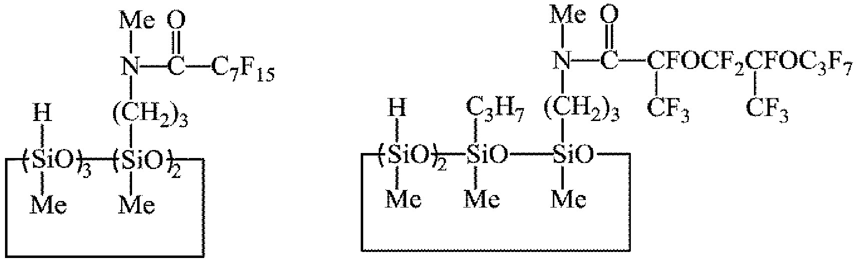

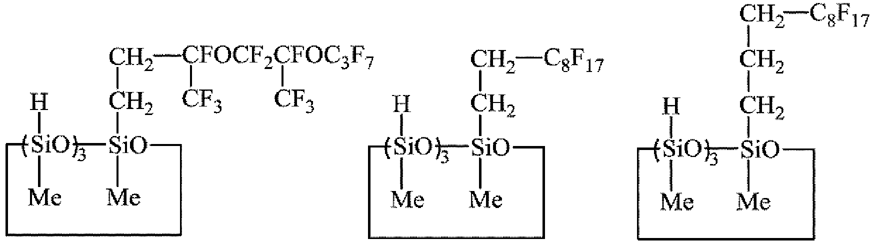

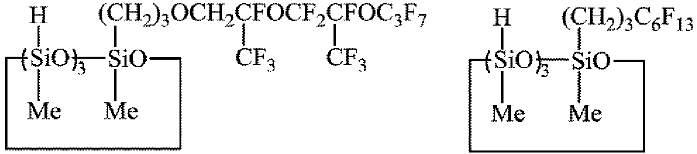

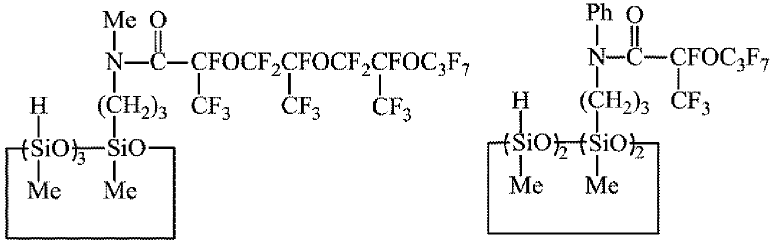

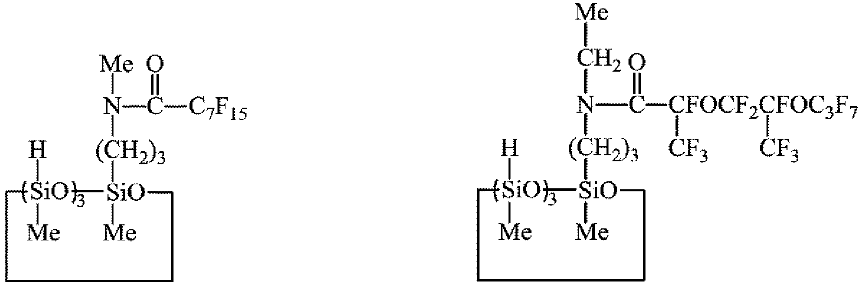

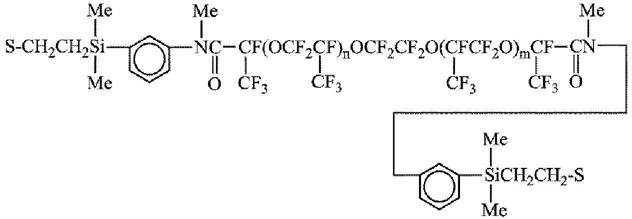

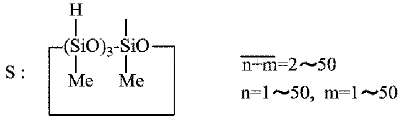

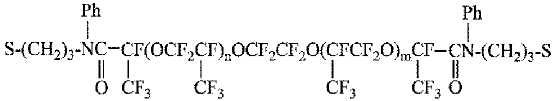

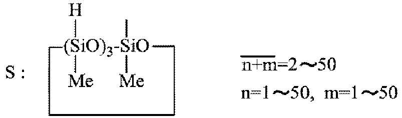

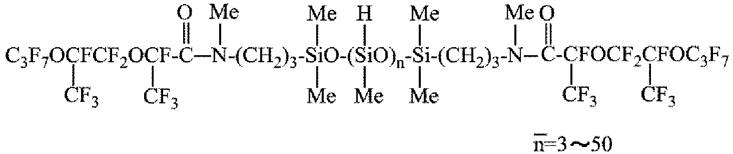

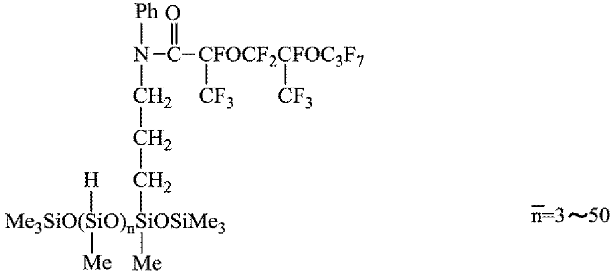

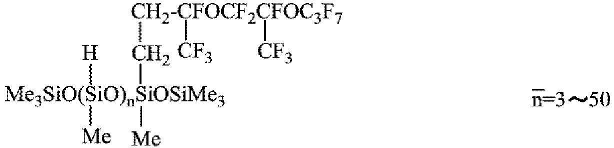

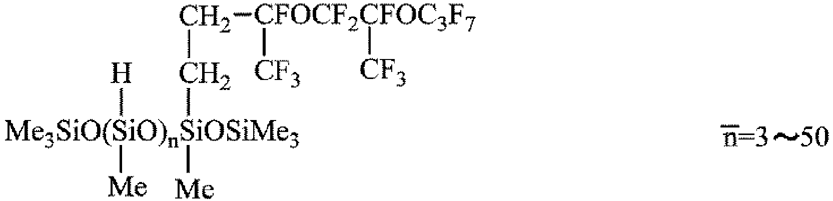

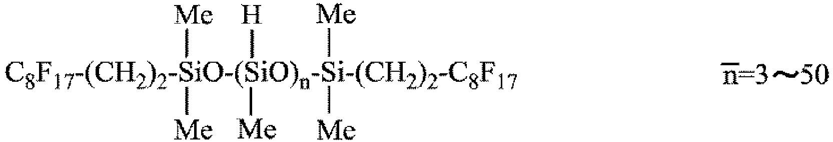

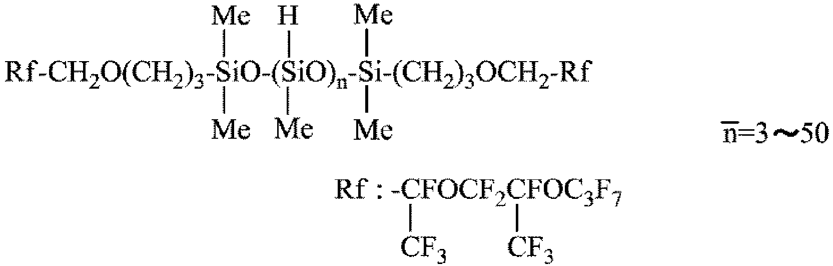

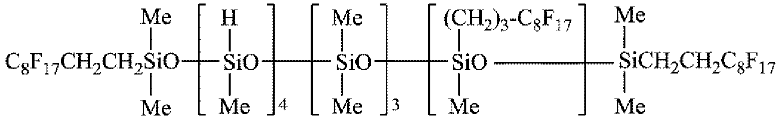

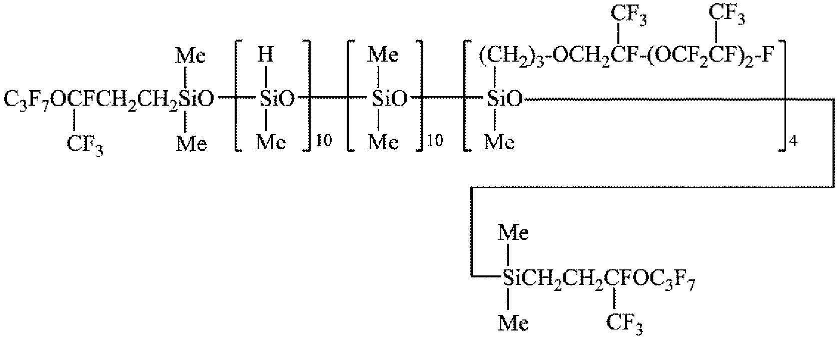

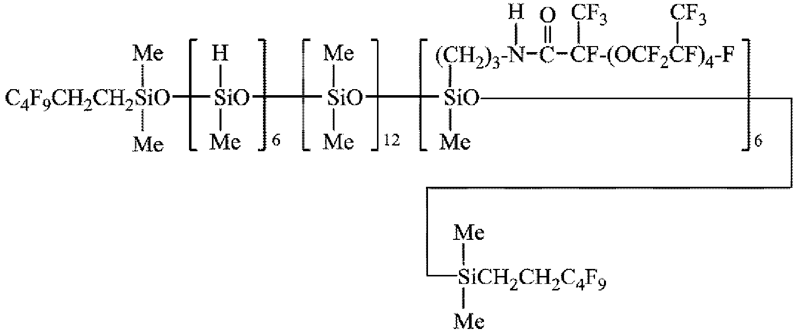

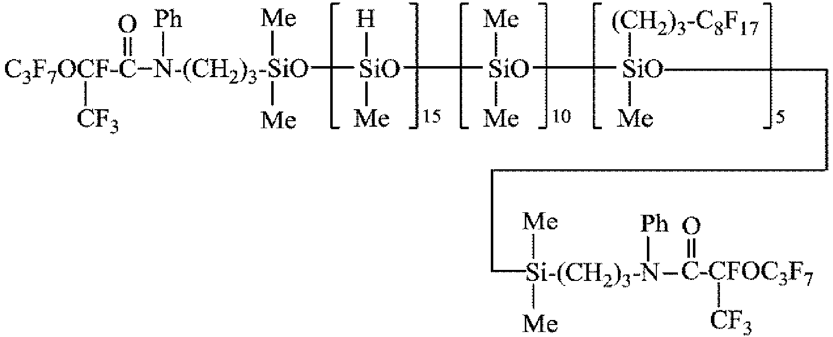

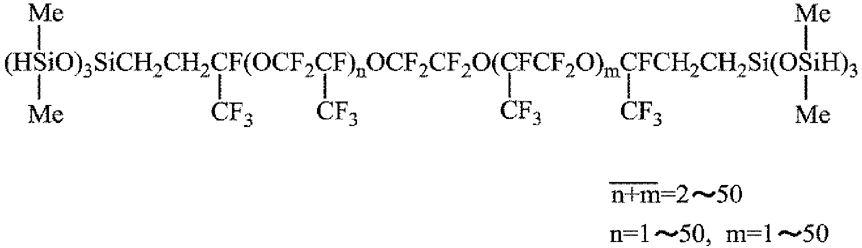

A blending amount of the component (C) is an effective amount for curing the component (A) and the component (E), described later, namely a curing effective amount. The blending amount is specifically an amount so that the hydrosilyl groups (Si-H) in the component (C) is preferably 0.2 to 4 mol, and more preferably 0.5 to 3 mol relative to 1 mol of a total amount of the alkenyl groups in the component (A) and, if present, the component (E) in the present composition. The hydrosilyl groups (Si-H) at an amount of 0.2 mol or more yields a sufficient crosslinking degree and causes no risk of failure to yield the cured product. The hydrosilyl groups (Si-H) at an amount of 4 mol or less causes no risk of foaming during curing.

The component (C) may be used singly, or may be used in combination of two or more.

### Component (D)

The hydrosilylation reaction catalyst (addition reaction catalyst) of the component (D) of the present invention is a catalyst for enhancing the addition reaction between: the alkenyl group in the component (A) or the alkenyl group in the component (E), described later; and the hydrosilyl group in the component (C). This hydrosilylation reaction catalyst is typically a compound of noble metal (platinum-group metal), which is expensive, and thereby easily available platinum or a platinum compound is usually used.

Examples of the platinum compound include chloroplatinic acid, a complex of chloroplatinic acid and an olefin such as ethylene, a complex of chloroplatinic acid and a vinylsiloxane, and metal platinum supported on silica, alumina, carbon, etc. As the platinum-group metal catalyst other than the platinum compound, rhodium, ruthenium, iridium, and palladium-based compounds are known, and examples thereof include RhCl(PPh₃)₃, RhCl(CO)(PPh₃)₂, Ru₃(CO)₁₂, IrCl(CO)(PPh₃)₂, and Pd(PPh₃)₄.

A blending amount of the hydrosilylation reaction catalyst may be a catalytic amount, and the hydrosilylation reaction catalyst is typically blended at a proportion of preferably 0.1 to 500 ppm (in terms of mass of the platinum-group metal), and more preferably 0.1 to 100 ppm relative to a total mass of the components (A), (C), and (E). The hydrosilylation reaction catalyst of the component (D) may be used singly, or may be used in combination of two or more.

### Component (E)

The component (E) is an optional component for reducing the crosslinking density to reduce the modulus in the curable perfluoropolyether gel composition of the present invention. The component (E) is a polyfluoromonoalkenyl compound having one alkenyl group in one molecule and a perfluoropolyether structure in the main chain. Specifically, polyfluoromonoalkenyl compounds represented by the following general formula (4) are preferable.

Rf²-(X')_{p'}-CH=CH₂ (4)

In the formula, X' represents -CH₂-, -OCH₂-, - CH₂OCH₂-, or -CO-NR²-Y'-, wherein Y' represents -CH₂- or a group represented by the following structural formula (Z'), and R² represents a hydrogen atom, a methyl group, a phenyl group, or an allyl group; "p'" represents 0 or 1; and Rf² represents a perfluoropolyether structure represented by the general formula F-[CF(CF₃)CF₂O]_{w'}-CF(CF₃)-, wherein "w'" represents an integer of 1 to 300, 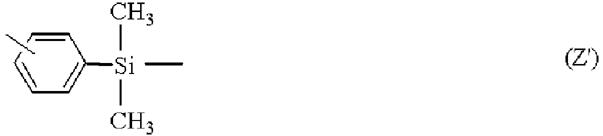 which is a dimethylphenylsilylene group represented with an ortho, meta, or para substitution position.

Specific examples of the polyfluoromonoalkenyl compound represented by the general formula (4) include the following compounds.

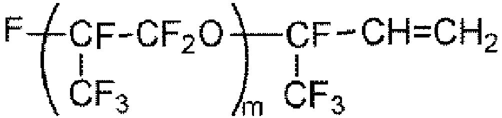

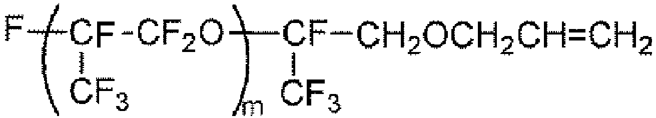

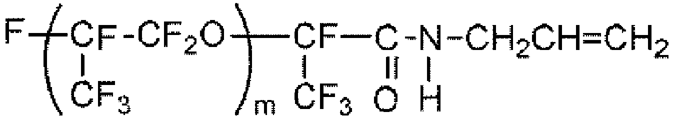

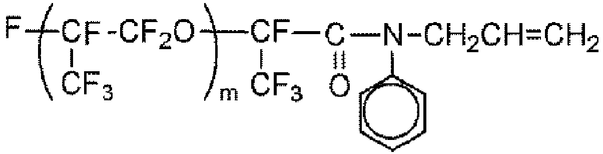

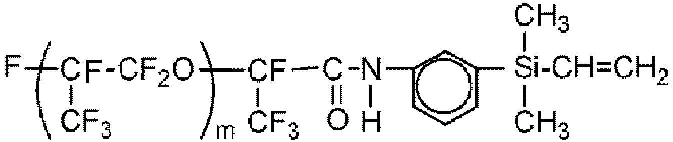

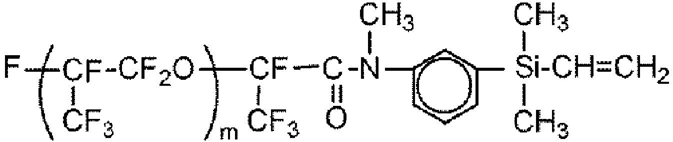

In the formulae, "m" represents an integer of 1 to 200, and particularly an integer of 2 to 100.

When the polyfluoromonoalkenyl compound represented by the formula (4) is blended, the blending amount can be selected to be 0 to 100 parts by mass, and preferably 1 to 50 parts by mass relative to 100 parts by mass of the total amount of the component (A) and the component (B) of the present composition in the curable perfluoropolyether gel composition.

The polyfluoromonoalkenyl compound of the component (E) may be used singly, or may be used in combination of two or more.

### Other Components

In the present composition, various blend agents are optionally added other than the components (A) to (E) .

### (Component (F))

The component (F), which is an optional component, is a controlling agent for the hydrosilylation reaction catalyst (curing-controlling agent). The component (F) may be added in order to prevent increase in the viscosity or gelation of the composition before the heating-curing, for example in preparing the above composition or in use of the composition. Examples thereof include: acetylene alcohols, such as 1-ethynyl-1-hydroxycyclohexane, 3-methyl-1-butyn-3-ol, 3,5-dimethyl-1-hexyn-3-ol, 3-methyl-1-penten-3-ol, and phenylbutynol; 3-methyl-3-penten-1-yne and 3,5-dimethyl-3-hexen-1-yne; polymethylvinylsiloxane cyclic compounds; and organophosphorus compounds. The addition thereof can appropriately keep the curing reactivity and the storage stability. The component (F) may be used singly, or may be used in combination of two or more.

A blending amount of the component (F) is within a range of 0 to 5 parts by mass relative to 100 parts by mass of the total amount of the component (A), the component (B), and the component (E). When the component (F) is blended, the blending amount is preferably within a range of 0.01 to 5 parts by mass, and more preferably within a range of 0.02 to 4 parts by mass. The blending amount of 5 parts by mass or less causes no risk of deterioration of curability of the obtained composition.

### (Filler)

In addition, examples of an inorganic filler include: silica-based fillers, such as surface-untreated or surface-hydrophobizing-treated fumed silica (dry silica), a precipitated silica (wet silica), colloidal silica, sol-gel silica, crystalline silica (quartz fine powder), melted silica, and crushed silica; iron oxide, zinc oxide, titanium oxide, calcium carbonate, magnesium carbonate, zinc carbonate, and carbon black. The addition thereof can regulate hardness and mechanical strength of the gel-like cured product obtained from the present composition. A hollow inorganic filler or a rubbery spherical filler may be added.

### (Adhesiveness-Imparting Agent)

To impart adhesiveness, a known adhesiveness-imparting agent containing an epoxy group, an alkoxy group, etc. may be added.

### (Surfactant)

Further, a known surfactant containing a fluorine group may be added in order to impart defoaming ability.

Use amounts of these blending components may be any according to the physical properties of the obtained composition and physical properties of the cured product.

A viscosity at 23°C of the composition in the present invention is necessarily 1000 mPa·s or less. If the viscosity is more than the above, there may be risk of increase in a time for removing foam generated during application of the composition on a substrate such as an electronic component or during injection. The viscosity can be measured in accordance with JIS K6249 by using a TV-10M-type rotary viscosimeter.

The curable perfluoropolyether gel composition of the present invention provides a perfluoropolyether gel cured product comprising a cured product thereof. Specifically, the curable perfluoropolyether gel composition preferably provides a perfluoropolyether gel cured product having a penetration of 5 to 80 in accordance with ASTM D-1403 (1/4 corn).

Such a curable perfluoropolyether gel composition can provide a gel cured product having appropriate softness.

### Cured Product

The present composition containing the above components can form a cured product having excellent solvent resistance, chemical resistance, etc. by curing these components.

The cured product is formed by a conventionally known method such as injecting the present composition into an appropriate mold and curing the composition, or applying the present composition on an appropriate substrate and then curing the composition. The curing can be easily performed by a heating treatment at a temperature of typically 60 to 150°C for approximately 30 to 180 minutes.

The cured product of the composition in the present invention necessarily has a resin modulus at 25°C of 0.1 to 200 kPa·s. If the resin modulus is less than 0.1 kPa·s, there may be risk of difficulty in shape retainability as the gel. If the resin modulus is more than 200 kPa·s, there may be risk of deterioration of adhesiveness to the substrate to impair reliability.

The resin modulus in the present invention means a storage elastic modulus (G') at a certain temperature measured by using a known dynamic viscoelasticity measuring device under shearing conditions at a frequency of 1 Hz, in which a shape of a sample (composition, cured product) has a thickness of 1.0 mm and a diameter of 20 mm.

### Electric or Electronic Component

Examples of an electric or electronic component encapsulated with the cured product of the present composition include a gas pressure sensor, a liquid pressure sensor, a temperature sensor, a humidity sensor, a rotation sensor, a G sensor, a timing sensor, an airflow meter, an electronic circuit, a semiconductor module, and various control units such as a computer control unit.

### EXAMPLE

Hereinafter, the present invention will be specifically described with showing Examples and Comparative Examples, but the present invention is not limited to the following Examples. In the following examples, "%" represents "mass%".

### Examples 1 to 4 and Comparative Examples 1 to 4

Curable perfluoropolyether gel compositions shown in Table 1 were prepared by using the following raw materials, and the compositions were subjected to a viscosity measurement, a foaming test, and a heat-shock test by the following methods. In addition, these gel compositions were cured under curing conditions at 150°C for 60 minutes, and the cured products were subjected to a penetration measurement, a solvent resistance test, a dynamic viscoelasticity measurement, and a DSC measurement by the following methods. Table 1 shows the results.

### Raw Materials

(A) Linear perfluoropolyether compound
   (a-1) Bifunctional perfluoropolyether
      (Perfluoropolyether 1)

      CH₂=CH-CH₂-O-CH₂-Rf-CH₂-O-CH₂-CH=CH₂

      (Rf: -CF₂O(CF₂CF₂O)₂₁(CF₂O)₂₂CF₂-, provided that the repeating units CF₂CF₂O and CF₂O were randomly arranged.)
   (a-2) Bifunctional perfluoropolyether
      (Perfluoropolyether 2)

      CH₂=CH-CH₂-O-CH₂-Rf-CH₂-O-CH₂-CH=CH₂

      (Rf: -CF₂O(CF₂CF₂O)₉₁(CF₂O)₈₃CF₂-, provided that the repeating units CF₂CF₂O and CF₂O were randomly arranged.)
   (a-3) Bifunctional perfluoropolyether
      (Perfluoropolyether 3) 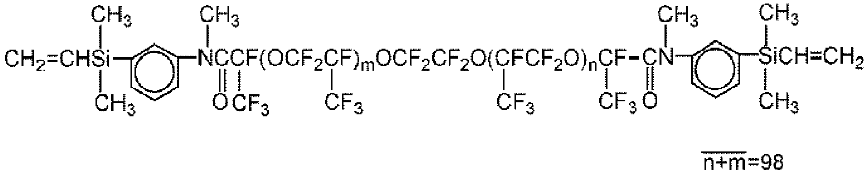
   (a-4) Bifunctional perfluoropolyether
      (Perfluoropolyether 4)

      CH₂=CH-CH₂-O-CH₂-Rf-CH₂-O-CH₂-CH=CH₂

      wherein Rf: - CF₂O (CF₂CF₂CF₂CF₂O)₁(CF₂CF₂CF₂O)₁(CF₂CF₂O)₃₉(CF₂O)₁₉CF₂-, provided that the repeating units; CF₂CF₂CF₂CF₂O, CF₂CF₂CF₂O, CF₂CF₂O, and CF₂O, were randomly arranged.
(B) Non-functional perfluoropolyether compound
   (b-1) Perfluoropolyether 5

      CF₃O-(CF₂CF₂CF₂O)_{b}-C₂F₅, wherein b=27
   (b-2) Perfluoropolyether 6

      CF₃-O-[(CF₂O)_{d}(CF₂CF₂O)ₑ]-CF₃

      (d+e=60, d=20, e=40 (average))
(C) Organohydrogenpolysiloxane
   (c-1) Organohydrogensiloxane 1 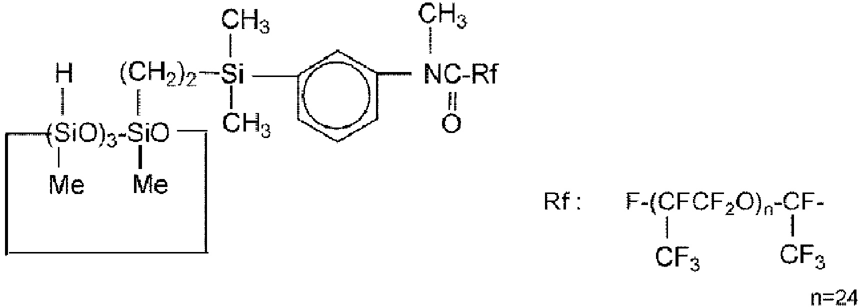
   (c-2) Organohydrogensiloxane 2 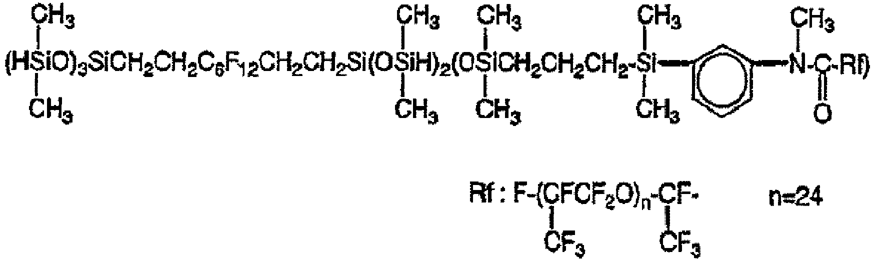
(D) Addition reaction catalyst (platinum compound): CAT-PL-50T (trade name, manufactured by Shin-Etsu Chemical Co., Ltd.)
(E) Monofunctional perfluoropolyether compound (Perfluoropolyether 7) 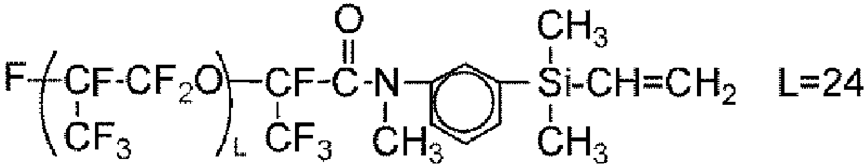
(F) Curing-controlling agent: ethynylcyclohexanol

### Viscosity Measurement

A viscosity at 23°C of each of the curable compositions obtained in Examples and Comparative Examples shown in Table 1 was measured. The viscosity was measured in accordance with JIS K6249 by using a TV-10M-type rotary viscosimeter.

### Foaming Test

Into a glass petri dish with ϕ30×14 mm, 12 g of each of the obtained compositions was charged and left to stand for 5 minutes. Thereafter, the composition with petri dish was put in a desiccator and defoamed under a reduced pressure. A case where the composition did not foam was judged as "Good", and a case where the composition foamed was judged as "Bad".

### Penetration Measurement

Into a glass petri dish with ϕ30×14 mm, 12 g of each of the obtained compositions was charged and cured under conditions at 150°C for 60 minutes to prepare a sample, and a penetration of the sample was measured. The penetration of the cured product was measured in accordance with ASTM D-1403 with a 1/4 corn.

### Solvent Resistance Test (Variation in Weight)

A glass container with 32ϕ×15 mm was filled with 3 g of each of the compositions of Examples 1 to 4 and Comparative Examples 1 and 4, and the composition was cured under conditions at 150°C for 60 minutes to prepare a sample. The sample was immersed in xylene at 25°C for seven days, and a variation rate of weight before and after the immersion was measured.

### Dynamic Viscoelasticity Measurement

Each of the compositions except for the composition of Comparative Example 2 was subjected to measurement by using a dynamic viscoelasticity measurement device. For a composition having a thickness of 1.0 mm and a diameter of 20 mm, dynamic viscoelasticity was measured at a frequency of 1 Hz, a strain of 100, and 150°C for 60 minutes to cure the composition. After cooling, the resin modulus (storage modulus G') was measured again at 25°C under the same conditions.

### Glass Transition Point Measurement

A glass transition point of the cured product of each of the compositions was determined within a range of -130°C to 25°C (temperature-rising rate: 5°C/min) by differential scanning calorimetry (DSC).

### Heat-Shock Test

An air-flow meter 1 illustrated in FIG. 1 was filled with each of the compositions which was subjected to cycles of -30°C (one hour) and 150°C (one hour) with 1000 cycles. A case where abnormality such as peeling from the substrate was not observed was judged as "Good", and a case where peeling was observed was judged as "Bad". The air-flow mater 1 has a detector 3, and is filled with each composition 2 so as to cover a part of the detector 3.

**[Table 1]**

| Composition (parts by mass) | | Example | | | | Comparative Example | | | |
|---|---|---|---|---|---|---|---|---|---|
| | | 1 | 2 | 3 | 4 | 1 | 2 | 3 | 4 |
| a-1 | Perfluoropolyether 1 | 80 | | | | 95 | 80 | | |
| a-2 | Perfluoropolyether 2 | | 45 | 20 | | | | 5 | |
| a-3 | Perfluoropolyether 3 | | | | | | | | 45 |
| a-4 | Perfluoropolyether 4 | | | | 50 | | | | |
| b-1 | Perfluoropolyether 5 | 20 | | 80 | | 5 | 20 | 95 | 55 |
| b-2 | Perfluoropolyether 6 | | 55 | | 50 | | | | |
| E | Perfluoropolyether 7 | | 5 | 2 | 5 | | | 2 | 5 |
| c-1 | Organohydrogensiloxane 1 | 13.4 | 11.4 | | 23.1 | 22.3 | | | 11.9 |
| c-2 | Organohydrogensiloxane 2 | | | 4.5 | | | | 1.3 | |
| D | Platinum compound | 0.11 | 0.11 | 0.11 | 0.11 | 0.11 | 0.11 | 0.11 | 0.11 |
| F | Curing-controlling agent | 0.33 | 0.33 | 0.33 | 0.33 | 0.33 | 0.33 | 0.33 | 0.33 |
| Viscosity (mPa·s) | | 106 | 722 | 350 | 150 | 165 | 85.2 | 174 | 1520 |
| Foaming test | | Good | Good | Good | Good | Good | Good | Good | Bad |
| Penetration | | 15 | 35 | 70 | 20 | 3 | not cured | unmeasurable | 58 |
| Solvent resistance (%) xylene | | 0.5 | 1.5 | 2.3 | 1.1 | 0.1 | - | - | 0.9 |
| Resin modulus (G', kPa·s, 25°C) | | 35 | 11 | 0.8 | 18 | 230 | - | 0.05 | 6.7 |
| Glass transition point (°C) | | -109 | -97 | -78 | -101 | -115 | - | - | -64 |
| Heat-shock test | | Good | Good | Good | Good | Bad | - | - | Good |

As shown in Table 1, the gel such as in Examples 1 to 4, which used the curable perfluoropolyether gel composition of the present invention, exhibited good defoaming ability after injection into the substrate and good adhesiveness in the heat-shock test. In addition, it is understood that the cured products obtained in the Examples have an appropriate penetration, have flexibility suitable for potting of electric or electronic component, exhibit sufficient solvent resistance even when containing the component (B) being the linear perfluoropolyether compound having no reactive functional group, which is not involved with the crosslinking reaction, in the molecule, and have excellent low-temperature characteristics due to the low glass transition temperature. Furthermore, the resin modulus is within an appropriate range, and thereby the shape retainability as gel and adhesiveness to the substrate are excellent. Since the composition of the present invention has the perfluoropolyether structure, the cured product (perfluoropolyether gel cured product) obtained from the composition has excellent chemical resistance.

In contrast, in Comparative Example 1, which used an excess amount of the component (A) being the essential component of the present invention, the resin modulus became high to decrease the adhesiveness. In Comparative Example 3, which used an excess amount of the component (B) being the essential component, the resin modulus became considerably low to find deterioration of shape retainability as gel. Comparative Example 2, which contained no component (C) being the essential component, failed to be completely cured. In Comparative Example 4, which was the perfluoropolyether composition having the branched structure in the main chain of the component (A), the viscosity was high to deteriorate defoaming ability, and thereby foaming was observed during the pressure-reducing treatment.

From the above, it has been found that the present invention provides the fluorine-containing curable gel composition that has excellent heat resistance, chemical resistance, low-temperature characteristics, adhesiveness, etc. after curing, that particularly exhibits good defoaming property in a short time even with use for potting, an encapsulating material, a coating material, etc. for an electric or electronic component due to a low viscosity before curing, and that can be suitably used for improving productivity.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A curable perfluoropolyether gel composition, comprising following components (A) to (D):
(A) 10 to 90 parts by mass of a linear perfluoropolyether compound containing two or more alkenyl groups in one molecule and a perfluoropolyether structure having a repeating unit of -CₐF₂ₐO- in a main chain, wherein the main chain has no branched structure, and "a" represents an integer of 1 to 6;
(B) 10 to 90 parts by mass of a linear perfluoropolyether compound containing a perfluoropolyether structure having no reactive functional group in one molecule, wherein a total amount of the component (A) and the component (B) is 100 parts by mass;
(C) a curing effective amount of an organohydrogenpolysiloxane having two or more hydrogen atoms bonded to a silicon atom in one molecule; and
(D) a catalytic amount of a hydrosilylation reaction catalyst,
wherein the composition before curing has a viscosity at 23°C of 1000 mPa·s or less, and the composition provides a perfluoropolyether gel cured product having a resin modulus at 25°C after curing of 0.1 to 200 kPa·s.

2. The curable perfluoropolyether gel composition according to claim 1, wherein the component (A) is a linear perfluoropolyether compound represented by the following general formula (1),
CH₂=CH-(X')ₚ-Rf¹-(X')ₚ-CH=CH₂ (1)
wherein X' represents -CH₂-, -OCH₂-, -CH₂OCH₂-, or - CO-NR²-Y'-, Y' represents -CH₂- or a group represented by the following structural formula (Z'), 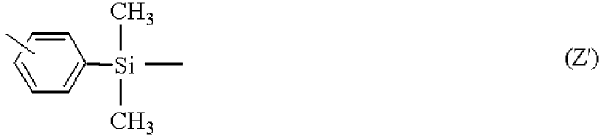
which is a dimethylphenylsilylene group represented with an ortho, meta, or para substitution position,
R² represents a hydrogen atom, a methyl group, a phenyl group, or an allyl group; "p" independently represents 0 or 1; and Rf¹ represents a perfluoropolyether structure represented by the general formula -[CₐF₂ₐO]_{w}-CF₂-, wherein "a" represents an integer of 1 to 6, "w" represents an integer of 1 to 300, and Rf¹ has no branched structure.

3. The curable perfluoropolyether gel composition according to claim 1 or 2, wherein the component (B) is one or more linear perfluoropolyether compounds selected from the group consisting of:
a compound represented by the following general formula (2),
A-O-(CF₂CF₂CF₂O)_{b}-A (2)
wherein A independently represents a group represented by the formula: CₛF₂ₛ₊₁-, wherein "s" represents an integer of 1 to 3, and "b" represents an integer of 1 to 200; and
a compound represented by the following general formula (3),
A-O-(CF₂O)_{d}(CF₂CF₂O)ₑ-A (3)
wherein A represents the above, "d" and "e" each represent an integer of 0 to 200, and d+e = 1 to 250.

4. The curable perfluoropolyether gel composition according to any one of claims 1 to 3, further comprising, as a component (E), a polyfluoromonoalkenyl compound represented by the following general formula (4),
Rf²-(X')_{p'}-CH=CH₂ (4)
wherein X' represents -CH₂-, -OCH₂-, -CH₂OCH₂-, or - CO-NR²-Y'-, Y' represents -CH₂- or a group represented by the following structural formula (Z'), 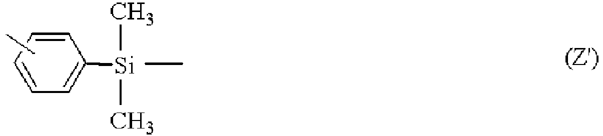
which is a dimethylphenylsilylene group represented with an ortho, meta, or para substitution position,
R² represents a hydrogen atom, a methyl group, a phenyl group, or an allyl group; "p'" represents 0 or 1; and Rf² represents a perfluoropolyether structure represented by the general formula F-[CF(CF₃)CF₂O]_{w'}-CF(CF₃)-, wherein "w'" represents an integer of 1 to 300.

5. The curable perfluoropolyether gel composition according to any one of claims 1 to 4, wherein the composition provides a perfluoropolyether gel cured product having a penetration of 5 to 80 in accordance with ASTM D-1403 (1/4 corn).

6. A perfluoropolyether gel cured product, comprising a cured product of the curable perfluoropolyether gel composition according to any one of claims 1 to 5.

7. An electric or electronic component encapsulated with the perfluoropolyether gel cured product according to claim 6.

8. The electric or electronic component according to claim 7, wherein the electric or electronic component is any one selected from the group consisting of a gas pressure sensor, a liquid pressure sensor, a temperature sensor, a humidity sensor, a rotation sensor, a G sensor, a timing sensor, an airflow meter, an electronic circuit, a computer control unit, and a semiconductor module.
